(19) Europäisches Patentamt / European Patent Office / Office européen des brevets

(11) **EP 2 905 813 A1**

(12) **EUROPEAN PATENT APPLICATION**
published in accordance with Art. 153(4) EPC

(43) Date of publication:
**12.08.2015 Bulletin 2015/33**

(51) Int Cl.:
**H01L 31/04** (2014.01)   **H01B 1/22** (2006.01)

(21) Application number: **13842622.6**

(22) Date of filing: **19.09.2013**

(86) International application number:
**PCT/JP2013/075352**

(87) International publication number:
**WO 2014/050704 (03.04.2014 Gazette 2014/14)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **26.09.2012   JP 2012212644**

(71) Applicant: **Murata Manufacturing Co., Ltd.
Nagaokakyo-shi, Kyoto 617-8555 (JP)**

(72) Inventor: **TAKEI Shodo
Nagaokakyo-shi
Kyoto 617-8555 (JP)**

(74) Representative: **Thoma, Michael
Lorenz - Seidler - Gossel
Rechtsanwälte Patentanwälte Partnerschaft mbB
Widenmayerstraße 23
80538 München (DE)**

(54) **CONDUCTIVE PASTE AND SOLAR CELL**

(57)    The conductive paste contains at least a conductive powder, a glass frit and an organic vehicle; and the glass frit contains Te, Ba, Bi, and at least one element selected from the group of Li, Na and K. A molar content of the Ti, the Ba, and the Bi is 55-85 mol%, 0.1-35 mol%, and 0.1-25 mol%, in terms of oxides thereof, respectively, and the molar content of at least one element selected from the group of Li, Na and K is 0.1-15 mol% in terms of oxides thereof. Light-receiving surface electrodes (3) are formed using the conductive paste. The conductive paste suitable for the forming a solar cell electrode is achieved, and the paste being capable of reducing the contact resistance between the electrodes (3) and the semiconductor substrate (1). By using the conductive paste, a solar cell having high energy conversion efficiency and excellent cell characteristics, is realized.

## Fig. 1

**Description**

TECHNICAL FIELD

The present invention relates to a conductive paste and a solar cell, and more particularly relates to a conductive paste suitable for forming electrodes of a solar cell and a solar cell produced by using the conductive paste.

BACKGROUND ART

A solar cell usually has light-receiving surface electrodes of a predetermined pattern formed on one side of a main surface of a semiconductor substrate. More, an antireflective film is formed on the semiconductor substrate excluding the above-light-receiving surface electrodes, and the reflection loss of incident solar light is suppressed by the antireflective film, and thereby the conversion efficiency of solar light into electric energy is improved.

By using a conductive paste, the light-receiving surface electrodes is usually formed as follows. That is, the conductive paste contains a conductive powder, a glass frit, and an organic vehicle, and the conductive paste is applied onto a surface of an antireflective film formed on a semiconductor substrate, so that a conductive film having a predetermined pattern is formed. Subsequently, the glass frit is fused in a firing process, and the antireflective film located at a lower layer of the conductive film is decomposed and removed, and thereby the conductive film is sintered to form light-receiving surface electrodes, and the light-receiving surface electrodes and the semiconductor substrate are adhered, thereby electrically coupling them.

As described above, a method of decomposing and removing the antireflective film to adhere the semiconductor substrate and the light-receiving surface electrodes in a firing process is called a fire-through, and the conversion efficiency of a solar cell is largely dependent on the fire-through performance. That is, it is known that, when the fire-through performance is insufficient, the conversion efficiency is reduced, consequently basic performance as a solar cell is inferior.

More, in this kind of a solar cell, it is preferred to use a low-softening point glass frit in order to enhance adhesive strength between the light-receiving surface electrodes and the semiconductor substrate.

As the low-softening point glass frit, Conventionally, a lead-based glass frit has been used. However the environmental burden of lead is large, and thus, the development of new materials in place of the lead-based glass frit has been required.

On the other hand, since the conversion efficiency of a solar cell is largely dependent on the fire-through performance, as described above, it is feared that, when the fire-through advances excessively so that the sintered light-receiving surface electrodes penetrates through the antireflective film to erode the semiconductor substrate, cell characteristics are deteriorated.

Then, the document 1 proposes a conductive paste for forming electrodes of a solar cell, including a conductive powder composed mainly of silver, a glass frit, an organic vehicle, and a solvent, wherein the glass frit includes a tellurium-based glass frit containing tellurium oxide as a network-forming component.

In the document 1, since the conductive paste contains a tellurium-based glass frit, even when the firing treatment is carried out, the light-receiving surface electrodes obtained after the sintering does not deeply erode the inside of the semiconductor substrate, and therefore the control of the fire-through performance is easy, and thereby a solar cell having good cell characteristics is attempted to realize, while being a lead-free type.

Furthermore, in the document 1, the tellurium-based glass frit contains, if necessary, a tungsten oxide and a molybdenum oxide in addition to the tellurium oxide, and contains any one or more of a zinc oxide, a bismuth oxide, an aluminum oxide and the like, and thereby enlargement of vitrification range and stabilization are designed.

The document 1: JP 2011-96747A (claims 1 and 6, pars. [0021]-[0028], and others)

SUMMARY OF INVENTION

Technical Problem

In the document 1, the contact resistance between the light-receiving surface electrodes and the semiconductor substrate is lowered by using the conductive paste containing the tellurium-based glass frit, and thereby the improvement of the cell characteristics of the solar cell is attempted. However, the contact resistance is dependent on the composition of the glass frit. That is, since the contact resistance is affected by the tellurium oxide, and other additives such as the tungsten oxide, the molybdenum oxide, and the like, it is difficult to maintain the low contact resistance stably.

The present invention has been made in view of such a situation, and it is an object of the present invention to provide a conductive paste suitable for forming solar cell electrodes that is capable of reducing the contact resistance between the electrodes and the semiconductor substrate, and a solar cell having high energy conversion efficiency and excellent cell characteristics by using the conductive paste.

Solution to Problem

In order to achieve the object, the inventor has made studies and a conductive paste is prepared so that a glass frit contains Te, Ba, Bi, and at least one element selected from the group of Li, Na and K in a predetermined range, in terms of the oxides thereof, respectively, and then the conductive paste is sintered to form electrodes, consequently, have found that it is possible to lower the contact resistance between electrodes and a semiconductor substrate, thereby making it possible to attain a solar cell having high energy conversion efficiency and excellent cell characteristics.

The present invention has been made based on such findings, and the conductive paste according to the invention is characterized by a conductive paste for forming electrodes of a solar cell, comprising at least a conductive powder, a glass frit; and an organic vehicle, wherein the glass frit contains Te, Ba, Bi, and at least one element selected from the group of Li, Na and K, as main components, and a molar content of the Te is 55 to 85 mol% in terms of $TeO_2$, a molar content of the Ba is 0.1 to 35 mol% in terms of BaO, a molar content of the Bi is 0.1 to 25 mol% in terms of $Bi_2O_3$, and a molar content of at least one selected from the group of the Li, the Na and the K is 0.1 to 15 mol% in terms of oxides thereof.

In the conductive paste of the present invention, it is preferable that a total molar content of the main components in the glass frit is 95 mol% or more in terms of oxides thereof.

In the conductive paste of the present invention, it is preferable that the glass frit contains at least one element selected from the group of Mg, Ca and Sr.

In case of including the Mg, the Ca and the Sr in the glass frit, it is also possible to realize a desired low contact resistance.

In the conductive paste of the present invention, it is preferable that the glass frit contains at least one element selected from the group of Al, Ti and Zr.

Thereby, it is possible to improve chemical durability of the glass.

In the conductive paste of the present invention, a content of the glass frit is preferably 1 to 10 wt%.

Thereby, it is possible to attain a conductive paste having excellent bondability between electrodes and a semiconductor substrate, and excellent solderability.

In the conductive paste of the present invention, the conductive powder is preferably an Ag powder.

Thereby, it is possible to attain electrodes having excellent conductivity even when the conductive paste is fired in an ambient atmosphere.

Furthermore, the solar cell according to the present invention is characterized by a solar cell comprising a semiconductor substrate, an antireflective film formed on one side of a main surface of the semiconductor substrate, and electrodes penetrating through the antireflective film, wherein the electrodes is formed by sintering the above-conductive paste.

Advantageous Effects of Invention

According to the conductive paste of the present invention, it is possible to lower the contact resistance between the electrode and the semiconductor substrate because the conductive paste comprises at least a conductive powder, a glass frit; and an organic vehicle, wherein the glass frit contains Te, Ba, Bi, and at least one element selected from the group of Li, Na and K, as main components, and a molar content of the Te is 55 to 85 mol% in terms of $TeO_2$, a molar content of the Ba is 0.1 to 35 mol% in terms of BaO, a molar content of the Bi is 0.1 to 25 mol% in terms of $Bi_2O_3$, and a molar content of at least one selected from the group of the Li, the Na and the K is 0.1 to 15 mol% in terms of oxides thereof.

Furthermore, according to the solar cell of the present invention, it is possible to attain the solar cell having energy conversion efficiency and excellent cell characteristics because the solar cell comprising the semiconductor substrate, the antireflective film formed on one side of a main surface of the semiconductor substrate, and the electrodes and penetrating through the antireflective film, wherein the electrodes is formed by sintering the above-conductive paste.

BRIEF EXPLANATION OF DRAWINGS

Fig. 1 is a cross-sectional view of a principal portion showing one embodiment of a solar cell produced by using a conductive paste according to the present invention.
Fig. 2 is an enlarged plan view schematically showing a light-receiving surface electrodes side.
Fig. 3 is an enlarged bottom view schematically showing a backside electrodes side.

DESCRIPTION OF EMBODIMENTS

An embodiment of the present invention will be described in detail.

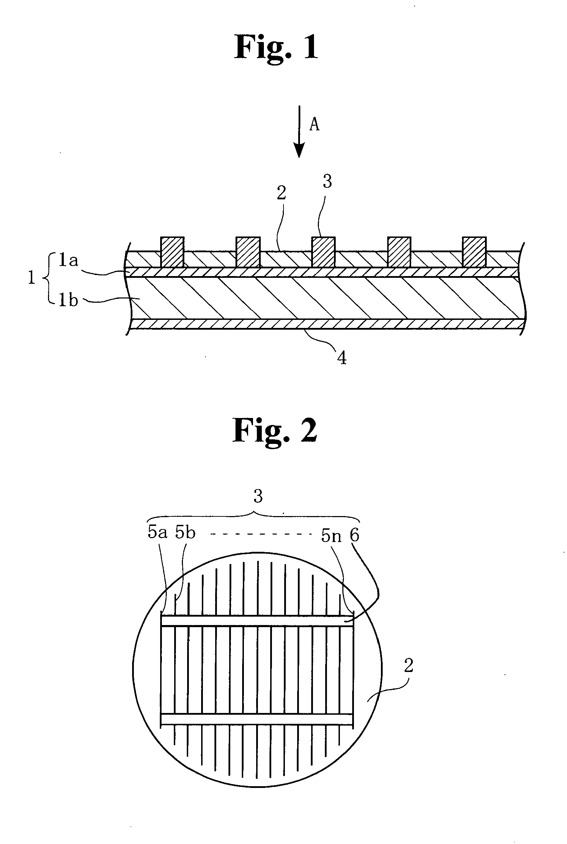

Fig.1 is a cross-sectional view of a principal portion showing an embodiment of a solar cell produced by using a conductive paste of the present invention.

In this solar cell, an antireflective film 2 and a light-receiving surface electrodes 3 are formed on one side of main surface of a semiconductor substrate 1 composed mainly of Si, and further a backside electrode 4 is formed on other side of the main surface of the semiconductor substrate 1.

The semiconductor substrate 1 has a p-type semiconductor layer 1b and an n-type semiconductor layer 1a, and the n-type semiconductor layer 1a is formed on the upper surface of the p-type semiconductor layer 1b.

The semiconductor substrate 1 can be obtained, for example, by diffusing impurities into one side of the main surface of the p-type semiconductor layer 1b of a monocrystal or polycrystal, and thereby, a thin n-type semiconductor layer 1a formed. Further, the semiconductor substrate 1 is not particularly limited regarding the structure and the production method thereof as long as the n-type semiconductor layer 1a is formed on the upper surface of the p-type semiconductor layer 1b. The semiconductor substrate 1 may be use substrate having a structure such that a thin p-type semiconductor layer is formed on one side of the main surface of an n-type semiconductor layer, or a structure such that both of a p-type semiconductor layer and an n-type semiconductor layer are formed on a part of one side of the main surface of the semiconductor substrate 1. In any case, the conductive paste of the present invention can be used effectively as long as the main surface of the semiconductor substrate 1 on which is formed the antireflective film 2 is applied.

In Fig.1, although the surface of the semiconductor substrate 1 is illustrated to a flat-shape, the surface is formed so as to have a texture structure in order to confine solar light into the semiconductor substrate 1 effectively.

The antireflective film 2 is composed of an insulating material such as a silicon nitride (SiNx), and suppresses reflection of solar light showed by an arrow A on the light-receiving surface to guide solar light promptly and effectively to the semiconductor substrate 1. The material composed of the antireflective film 2 is not limited to the silicon nitride, and other insulating materials, for example, a silicon oxide or a titanium oxide, may be used, and also a combination of two or more insulating materials may be used. Further, any one of single crystal Si and polycrystal Si may be used as long as it is a crystal Si-based material.

The light-receiving surface electrodes 3 are formed on the semiconductor substrate 1 to penetrate through the antireflective film 2. The light-receiving surface electrodes 3 are formed by using screen printing or the like, applying the conductive paste of the present invention described later onto the semiconductor substrate 1 to produce a conductive film, and subsequently firing. That is, the antireflective film 2 located at the lower layer of the conductive film is decomposed and removed to undergo a fire-through in the firing step of forming the light-receiving surface electrodes 3, and thereby the light-receiving surface electrodes 3 are formed on the semiconductor substrate 1 in the form of penetrating through the antireflective film 2.

Specifically, as illustrated in Fig. 2, in the light-receiving surface electrodes 3, many finger electrodes 5a, 5b, ... ... 5n are arranged in parallel in a comb-teeth shape, and a bus bar electrode 6 is arranged to intersect the finger electrodes 5a, 5b, ... ... 5n. The finger electrodes 5a, 5b, ... ... 5n are electrically connected to the bus bar electrode 6. The antireflective film 2 is formed in a remaining area excluding a portion where the light-receiving surface electrodes 3 is provided. In this way, the electric power generated in the semiconductor substrate 1 is collected through the finger electrodes 5a, 5b, ... ... 5n, and extracted to the outside through the bus bar electrode 6.

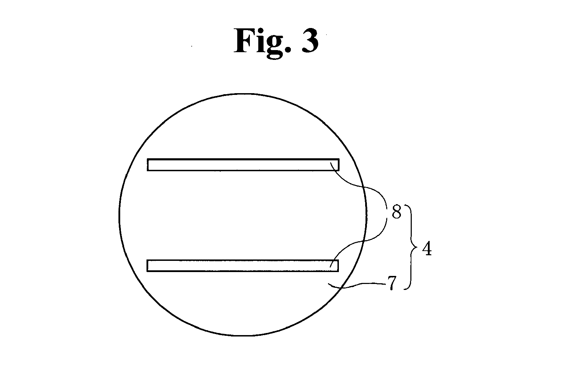

The backside electrode 4, as illustrated in Fig.3, specifically, consists of a collecting electrode 7 composed of Al or the like which is formed on the back surface of the p-type semiconductor layer 1b, and extraction electrodes 8 composed of Ag or the like which is connected electrically to the collecting electrode 7. The electric power generated in the semiconductor substrate 1 is collected to the collecting electrode 7, and then extracted the electric power through the extraction electrodes 8.

Next, the conductive paste of the present invention for forming the light-receiving surface electrode 3 will be described in detail.

The conductive paste of the present invention contains at least a conductive powder, a glass frit, and an organic vehicle.

The glass frit further contains 55 to 85 mol% of Te in terms of $TeO_2$, 0.1 to 35 mol% of Ba in terms of BaO, 0.1 to 25 mol% of Bi in terms of $Bi_2O_3$, and 0.1 to 15 mol% of at least one selected from Li, Na and K in terms of oxides thereof

Thereby, it is possible to lower the contact resistance between the light-receiving surface electrodes 3 and the semiconductor substrate 1, and consequently capable of obtaining the solar cell having high energy conversion efficiency and excellent cell characteristics.

Hereinafter, the reasons that the molar content of Te, Ba, Bi, and at least one element selected from the grope of Li, Na and K in the glass frit is limited to the above-mentioned range will be described.

(1) Molar content of Te

Glass is composed of a network former oxide which is amorphized to form a network structure, a modifier oxide which modifies the network former oxide to be made amorphous, and an intermediate oxide having an intermediate function between the network former and the modifier oxide. Of these, $TeO_2$ acts as the network former oxide and further the light-receiving surface electrodes after the sintering do not erode deeply the inside of the semiconductor substrate, and therefore the control of the fire-through performance is easy, and an important constituent component can be formed.
However, when the molar content of Te in terms of $TeO_2$ is less than 55 mol%, it is difficult to ensure a desired fire-through performance. On the other hand, when the molar content of Te in terms of $TeO_2$ is more than 85 mol%, the molar content of the other glass components becomes small extremely, so that it is difficult to vitrify.
Thus, in the present embodiment, the molar content of Te in the glass frit is set to 55 to 85 mol%, in terms of $TeO_2$.

(2) Molar content of Ba

BaO acts to adjust the fluidity of glass, as the modifier oxide, and also contributes to the advance of the fire-through performance.
In order to advance the fire-through performance, the molar content of Ba is needed at least 0.1 mol% and more, in terms of BaO. On the other hand, when the molar content of Ba is more than 35 mol%, in terms of BaO, it is difficult to vitrify.
Thus, in the present embodiment, the molar content of Bi in the glass frit is set to 0.1 to 35 mol%, in terms of BaO.

(3) Molar content of Bi

$Bi_2O_3$ acts to adjust the fluidity of glass, as the modifier oxide, and also contributes to the advance of the fire-through performance.
In order to advance the fire-through performance, the molar content of Bi is needed at least 0.1 mol% and more, in terms of $Bi_2O_3$. On the other hand, when the molar content of Bi is more than 25 mol%, in terms of $Bi_2O_3$, it is difficult to vitrify.
Thus, in the present embodiment, the molar content of Bi in the glass frit is set to 0.1 to 25 mol%, in terms of $Bi_2O_3$.

(4) Molar content of Li, Na and K

$Li_2O$, $Na_2O$, and $K_2O$, as a modified oxide, have a function of adjusting the softening point of glass as a modifier oxide, as well as BaO and $Bi_2O_3$, and advance crystallization in an appropriate temperature range, and therefore contribute to the improvement of fire-through performance.
For this purpose, it is necessary to contain 0.1 mol% or more of at least one element selected from the group of Li, Na and K, in terms of oxides thereof. On the other hand, when these elements are contained excessively the molar content of more than 15 mol%, in terms of oxides thereof, it is fear that chemical durability is deteriorated.
Thus, in the present embodiment, the molar content of at least one element selected from the group of Li, Na and K in the glass frit is set to 0.1 to 15 mol%, in terms of oxides thereof.
A total molar content of these main components - i.e. the Te, the Ba, the Bi, the Li, the Na, and the K - is preferably 95 mol% or more in the glass frit, in terms of oxides thereof. If the total molar content of these main components is less than 95 mol% in terms of oxides thereof, the molar content of additive components other than the main components is increased, so that the contact resistance cannot be sufficiently lowered.
Thus, various additives may be included in the glass frit, if necessary, as long as the molar content of the additives in the glass frit fall within the scope of less than 5 mol% in terms of oxides thereof.
For example, in the present embodiment, although the glass frit contains Ba as an alkaline earth metal, as an essential component, it is also preferred to contain any of Mg, Ca and Sr in addition to the Ba within the scope of less than 5 mol%, in terms of oxides thereof. Although MgO, CaO and SrO are inferior to the BaO in the fire-through performance, these oxides have the action of adjusting the fluidity of glass, as well as the BaO.
Furthermore, since Al, Ti, and Zr contribute to an improvement of the glass frit in chemical durability, the glass frit preferably contains within the scope of less than 5 mol%, in terms of oxides thereof, if necessary.
Besides, the addition form of these additives is not particularly limited, and the additive may be added in the form of, for example, an oxide, a hydroxide, a peroxide, a halide, a carbonate, a nitrate, a phosphate, a sulfate or a fluoride.
Although the content of the glass frit in the conductive paste is not particularly limited, it is preferably 1 to 10 wt%, more preferably 1 to 5 wt%. When the content of the glass frit is less than 1 wt%, the bondability between the electrodes and the semiconductor substrate may be lowered. On the other hand, when the content of the glass frit is more than 10 wt%, the glass component is excessively present on the electrodes surface after the firing, thereby causing the degradation of the solderability.

Although the conductive powder is not particularly limited as long as it is a metal powder having excellent conductivity, an Ag powder which can maintain excellent conductivity without being oxidized even when the firing treatment is carried out in an ambient atmosphere, may be preferably used. In addition, the shape of the conductive powder is not also particularly limited, and, for example, a spherical shape, a flattened shape, or an amorphous shape, or a mixture thereof can be used.

Although the average particle diameter of the conductive powder is not particularly limited, it is preferably 0.5 to 5.0 $\mu$m, in terms of a spherical powder, in view of ensuring a desired contact point between the conductive powder and the semiconductor substrate 1.

More, although the content of the conductive powder in the conductive paste is not particularly limited, it is preferably 80 to 95 wt%. When the content of the conductive powder is less than 80 wt%, a film thickness of the electrodes becomes thinner, as a result, the line resistance tends to increase. On the other hand, when the content of the conductive powder is more than 95 wt%, the content of the organic vehicle or the like is decreased, and therefore pasting becomes difficulty.

The organic vehicle is prepared in such a manner that a volume ratio between a binder resin and an organic solvent is, for example, 1:9 to 3:7. The binder resin is not particularly limited, and for example, an ethyl cellulose resin, a nitrocellulose resin, an acrylic resin, an alkyd resin, and any combination of two or more of these resins can be used. The organic solvent is not also particularly limited, and texanol, $\alpha$-terpineol, xylene, toluene, diethylene glycol monobutyl ether, diethylene glycol monobutyl ether acetate, diethylene glycol monoethyl ether, and diethylene glycol monoethyl ether acetate and the like can be used singly, or in combination thereof.

In addition, it is also preferred to add, a kind of plasticizer such as diethylhexyl phthalate or dibutyl phthalate, or a combination of two or more thereof in the conductive paste, if necessary. It is also preferred that a rheology-adjusting agent such as fatty acid amide or fatty acid is added, and further a thixotropic agent, a thickening agent, a dispersing agent or the like may be added.

The conductive paste can be easily produced by weighing and mixing the conductive powder, the glass frit, the organic vehicle, and further various additives, if necessary, so as to have a predetermined mixture ratio, and dispersing and kneading by using a triple roll mill or the like.

As described above, in the present conductive paste, it is possible to lower the contact resistance between the light-surface electrodes 3 and the semiconductor substrate 1 because the conductive paste comprises at least the conductive powder, the glass frit, and the organic vehicle, wherein the glass frit contains 55 to 85 mol% of Te in terms of $TeO_2$, 0.1 to 35 mol% of Ba in terms of BaO, 0.1 to 25 mol% of Bi in terms of $Bi_2O_3$, and 0.1 to 15 mol% of at least one element selected from the group of Li, Na and K in terms of oxides thereof, respectively.

More, when the glass frit contains Mg, Ca and Sr fall within the scope of less than 5 mol% in terms of oxides thereof, the fluidity of glass is adjustable, and a desired contact resistance can be realized.

Further, when the glass frit contains Al, Ti and Zr within the scope of less than 5 mol% in terms of oxides thereof, chemical durability of the glass frit can be improved.

In the present solar cell, the contact resistance between the electrode and the semiconductor substrate can be lowered because the solar cell comprises the semiconductor substrate, the antireflective film formed on one side of main surface of the semiconductor substrate, and the electrodes penetrating through the antireflective film, wherein the electrodes is formed by sintering the above-conductive paste, and thereby it is possible to attain the solar cell having high energy conversion efficiency and excellent cell characteristics.

Besides the present invention is not limited to this embodiment. For example, the constituent components of the conductive paste can be included the various inorganic additives as long as the cell characteristics are not affected.

In the above-embodiment, although the conductive paste is used for forming the light-receiving surface electrodes, it may be further used for forming the backside electrode.

Next, examples of the present invention will be described specifically.

EXAMPLE

Production of Samples

(Production of conductive paste)

As materials for glass, $TeO_2$, BaO, $Bi_2O_3$, $Li_2O$, $Na_2O$, $K_2O$, MgO, CaO, SrO, $Al_2O_3$, $ZrO_2$, $Ta_2O_5$, and $MoO_3$ were prepared. These glass materials were weighed and prepared to have a blend proportion, as shown in Table 1, and thereby a glass frit of sample Nos. 1 to 11 was produced, respectively.

Table 1

| Sample No. | Glass composition (mol%) | | | | | | | | | | | | |
|---|---|---|---|---|---|---|---|---|---|---|---|---|---|
| | $TeO_2$ | BaO | $Bi_2O_3$ | $Li_2O$ | $Na_2O$ | $K_2O$ | MgO | CaO | SrO | $Al_2O_3$ | $TiO_2$ | $ZrO_2$ | $MoO_3$ |
| 1 | 85.0 | 0.1 | 7.9 | - | 7.0 | - | - | - | - | - | - | - | - |
| 2 | 55.0 | 23.0 | 6.9 | 15.0 | - | 0.1 | - | - | - | - | - | - | - |
| 3 | 70.0 | 9.9 | 15.0 | 0.1 | 5.0 | - | - | - | - | - | - | - | - |
| 4 | 55.0 | 35.0 | 4.9 | - | 0.1 | 5.0 | - | - | - | - | - | - | - |
| 5 | 55.0 | 5.0 | 25.0 | - | 15.0 | - | - | - | - | - | - | - | - |
| 6 | 65.0 | 19.0 | 0.1 | 0.9 | - | 15.0 | - | - | - | - | - | - | - |
| 7 | 65.0 | 13.0 | 7.0 | 10.0 | - | - | 3.5 | - | - | 1.0 | 0.5 | - | - |
| 8 | 65.0 | 13.0 | 7.0 | 5.0 | - | 5.0 | - | 4.0 | - | - | - | 1.0 | - |
| 9 | 65.0 | 13.0 | 7.0 | - | 5.0 | 5.0 | - | - | 2.5 | - | 2.5 | - | - |
| 10* | 70.0 | - | 10.0 | - | - | - | - | - | - | - | - | - | 20.0 |
| 11* | 73.8 | 10.4 | 15.8 | - | - | - | - | - | - | - | - | - | - |
| * indicates outside the scope of the present invention | | | | | | | | | | | | | |

As a conductive powder, a spherical Ag powder having an average particle diameter of 1.6 μm was prepared.

Then, an organic vehicle was produced. That is, an ethyl cellulose resin and texanol were mixed so that an ethyl cellulose resin as a binder resin was 10 wt% and texanol as an organic solvent was 90 wt% to produce an organic vehicle.

Then, 86.0 wt% of the Ag powder and 3.0 wt% of the glass frit were mixed together with a rheology-adjusting agent such as an aliphatic acid amide, aliphatic acid, or the like and the organic vehicle, and the resulting mixture was mixed with a planetary mixer and then kneaded with a triple roll mill to produce conductive pastes of sample Nos. 1 to 11.

(Production of solar cells)

An antireflective film having a film thickness of 0.1 μm was formed on the entire surface of a monocrystal Si-based semiconductor substrate having a length of 50 mm, a width of 50 mm and a thickness of 0.2 mm by plasma-enhanced chemical vapor deposition method (PECVD). In the Si-based semiconductor substrate, a phosphorus (P) is diffused into a part of a p-type Si-based semiconductor layer, and thereby an n-type Si-based semiconductor layer is formed on the upper surface of the p-type Si-based semiconductor layer.

Next, an Al paste composed mainly of Al, and an Ag paste composed mainly of Ag were prepared. The Al paste and the Ag paste were applied onto the back surface of the Si-based semiconductor substrate appropriately, and the resultant was dried, thereby forming a conductive film for backside electrode.

Next, Using the above-mentioned conductive paste, screen printing was performed, and was applied onto the surface of the Si-based semiconductor substrate so that a film thickness after the firing becomes 20 μm, and thereby a conductive film for light-receiving surface electrodes was produced.

Next, each of the sample was put into an oven which set to a temperature of 150°C, and dried the conductive film.

Thereafter, with use of a belt-type near infrared furnace (CDF7210, manufactured by Despatch), the conveying speed of the sample was adjusted so that the sample passed through about one minute from the inlet to the outlet, and was fired at a maximum firing temperature of 760 to 800°C in an ambient atmosphere, and thereby a solar cell of sample Nos. 1 to 11 on which the conductive paste was sintered to form light-receiving surface electrodes, was produced respectively. The reason the maximum firing temperature was set to 760 to 800°C is that the maximum firing temperature optimal for such a paste is varied in accordance with the composition thereof.

Evaluation of Samples

In each of the sample Nos. 1 to 11, using a solar simulator (SS-50XIL, manufactured by EKO Instruments), a current-voltage characteristic curve under conditions of a temperature of 25°C and an AM (air mass) of 1.5 was measured, and then, the fill factor FF of the sample was calculated based on the current-voltage characteristic curve, in accordance with the mathematical formula (1).

$$FF = Pmax/(V_{OC} \times I_{SC}) \ . \ . \ .(1)$$

Wherein Pmax is the maximum power of the sample; $V_{OC}$ is an open-circuit voltage generated when the output terminals are opened; and $I_{SC}$ is a short circuit current generated when the output terminals are short-circuited there-between.

The conversion efficiency $\eta$ of the sample was calculated based on the maximum power Pmax, an area A of the light-receiving surface electrodes, and an irradiance E, in accordance with the mathematical formula (2).

$$\eta = Pmax \ (A \times E) \ . \ . \ . \ (2)$$

Table 2 shows the paste composition, the fill factor FF, the conversion efficiency $\eta$, and the evaluation result of the sample Nos. 1 to 11, respectively.

Table 2

| Sample No. | Cell characteristics | |
|---|---|---|
| | Fill factor FF | Conversion factor $\eta$ (%) |
| 1 | 0.775 | 16.60 |
| 2 | 0.774 | 16.57 |
| 3 | 0.776 | 16.62 |
| 4 | 0.765 | 16.38 |
| 5 | 0.781 | 16.73 |
| 6 | 0.771 | 16.51 |
| 7 | 0.770 | 16.49 |
| 8 | 0.773 | 16.55 |
| 9 | 0.775 | 16.60 |
| 10* | 0.712 | 15.21 |
| 11* | 0.750 | 16.05 |
| * indicates outside the scope of the present invention | | |

In the sample No. 10, the fill factor FF was as low as 0.712, and the conversion factor $\eta$ was as low as 15.12%. The reason for this is thought that, in the glass frit, any of BaO, $Li_2O$, $Na_2O$ and $K_2O$ is not contained, while $MoO_3$, which is outside the scope of the present invention, is contained, and thus, the fire-through performance is inferior, so that the contact resistance is increased, and the cell characteristics is deteriorated.

In the sample No. 11, the fill factor FF was 0.750, and the conversion factor $\eta$ was 16.05%, and therefore although these factors are improved as compared with sample 10, sufficient cell characteristics could not be obtained yet. The reason for this is thought that the contact resistance is not sufficiently lowered because any of $Li_2O$, $Na_2O$ or $K_2O$ is not contained in glass frit.

On the other hand, in the samples Nos. 1 to 9, the molar content of $TeO_2$ was 55.0 to 35.0 mol%, the molar content of BaO was 0.1 to 35.0 mol%, the molar content of $Bi_2O_3$ was 0.1 to 25.0 mol%, and the molar content of $Li_2O$, $Na_2O$ and/or $K_2O$ was 0.1 to 15.0 mol%, and these contents fall within the scope of the present invention, and therefore the fill factor FF was 0.765 to 0.781, and the conversion factor $\eta$ was 16.38 to 16.73%, so that excellent cell characteristics could be obtained.

INDUSTRIAL APPLICABILITY

The contact resistance between the electrodes and the semiconductor substrate can be lowered, and thereby it is possible to attain the solar cell having high energy conversion efficiency.

REFERENCE SIGNS LIST

1    Semiconductor substrate
2    Antireflective film
3    Light-receiving surface electrode (electrode)

**Claims**

1.  A conductive paste for forming electrodes of a solar cell, comprising at least:

    a conductive powder;
    a glass frit; and
    an organic vehicle,
    wherein the glass frit contains Te, Ba, Bi, and at least one element selected from the group of Li, Na and K, as main components, and
    a molar content of the Te is 55 to 85 mol% in terms of $TeO_2$, a molar content of the Ba is 0.1 to 35 mol% in terms of BaO, a molar content of the Bi is 0.1 to 25 mol% in terms of $Bi_2O_3$, and a molar content of at least one selected from the group of the Li, the Na and the K is 0.1 to 15 mol% in terms of oxides thereof.

2.  The conductive paste according to claim 1, wherein a total molar content of the main components in the glass frit is 95 mol% or more in terms of oxides thereof.

3.  The conductive paste according to claim 1 or 2, wherein the glass frit contains at least one element selected from the group of Mg, Ca and Sr.

4.  The conductive paste according to any one of claims 1 to 3, wherein the glass frit contains at least one element selected from the group of Al, Ti and Zr.

5.  The conductive paste according to any one of claims 1 to 4, wherein a content of the glass frit is 1 to 10 wt%.

6.  The conductive paste according to any one of claims 1 to 5, wherein the conductive powder is an Ag powder.

7.  A solar cell comprising:

    a semiconductor substrate;
    an antireflective film formed on one side of a main surface of the semiconductor substrate; and
    electrodes and penetrating through the antireflective film,
    wherein the electrodes is formed by sintering the conductive paste according to any one of claims 1 to 6.

# Fig. 1

# Fig. 2

# Fig. 3

## INTERNATIONAL SEARCH REPORT

International application No.

PCT/JP2013/075352

### A. CLASSIFICATION OF SUBJECT MATTER
*H01L31/04*(2006.01)i, *H01B1/22*(2006.01)i

According to International Patent Classification (IPC) or to both national classification and IPC

### B. FIELDS SEARCHED

Minimum documentation searched (classification system followed by classification symbols)
H01L31/04, H01B1/22

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2013 |
| Kokai Jitsuyo Shinan Koho | 1971-2013 | Toroku Jitsuyo Shinan Koho | 1994-2013 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X<br>A | JP 2011-96747 A  (Shoei Chemical Inc.),<br>12 May 2011 (12.05.2011),<br>entire text; all drawings<br>& US 2011/0095240 A1   & EP 2317523 A1<br>& CA 2718204 A       & CN 102081986 A<br>& TW 201120163 A | 1,3-7<br>2 |
| A | JP 2012-84585 A  (Shoei Chemical Inc.),<br>26 April 2012 (26.04.2012),<br>entire text; all drawings<br>& US 2013/0167923 A1   & EP 2626908 A<br>& WO 2012/046719 A1   & TW 201220516 A<br>& CA 2813668 A       & CN 103155159 A | 1-7 |

☐ Further documents are listed in the continuation of Box C.    ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 03 October, 2013 (03.10.13) | 15 October, 2013 (15.10.13) |

| Name and mailing address of the ISA/<br>Japanese Patent Office | Authorized officer |
|---|---|
| Facsimile No. | Telephone No. |

Form PCT/ISA/210 (second sheet) (July 2009)

**EP 2 905 813 A1**

**REFERENCES CITED IN THE DESCRIPTION**

**Patent documents cited in the description**

- JP 2011096747 A